# EUROPÄISCHE PATENTANMELDUNG

(11) **EP 0 625 709 A1**
(43) Veröffentlichungstag der Anmeldung: **23.11.1994**
(21) Anmeldenummer: 94107426.2
(22) Anmeldetag: 13.05.1994
(51) Int. Cl.: G01R 1/067, H01R 13/17

(54) **Prüfspitze für elektrische Messgeräte, insbesondere Spannungsmesser**

(30) Priorität: 18.05.1993 CH 1508/93
(71) Anmelder: MDM Elektrosystem AG, CH-8620 Wetzikon (CH)
(72) Erfinder: De Monaco, Edoardo, CH-8344 Bäretswil (CH)
(74) Vertreter: Petschner, Goetz

(57) **Zusammenfassung**

Die Prüfspitze für elektrische Messgeräte, insbesondere Spannungsmesser, ist gekennzeichnet durch Mittel zum Selbsthalten der Prüfspitze in einer Steckdosenbuchse beliebiger Bauart, welche Mittel eine, an einem Kontaktstift (1) teilweise anliegende, zur Kontaktstiftspitze hin doppelseitig ausbauchende Kontaktfeder (2) umfassen.

Daraus ergibt sich eine universell einsetzbare, sich in jeder Buchsenform unterschiedlichster Steckdosen selbsthaltende Prüfspitze, wobei jederzeit Berührungsschutz gewährleistet ist.

## Beschreibung

Die vorliegende Erfindung betrifft eine Prüfspitze für elektrische Messgeräte, insbesondere Spannungsmesser.

Es ist bekannt, dass u.a. jede installierte Steckdose nach den NIV-Vorschriften geprüft werden muss, etwa auf richtigen Drehsinn. Dies verlangt den gleichzeitigen Abgriff von 3 Leitern, was allerdings bei Verwendung bisher üblicher Prüfspitzen und zusätzlicher Bedienung des betreffenden Messgerätes mehr als eine Person erfordert. Zudem sind für die Vielzahl vorhandener Steckdosen unterschiedlicher Buchsenformen Adapter unerlässlich, um jeweils die gleichen Prüfspitzen verwenden zu können.

Es ist deshalb Aufgabe der vorliegenden Erfindung, eine Prüfspitze für elektrische Messgeräte, insbesondere Spannungsmesser zu schaffen, welche auf jede Art Buchsenformen von Steckdosen passt und welche eine Handhabung von mehreren solcher Prüfspitzen gleichzeitig und ohne Hilfspersonen erlaubt.

Dies wird erfindungsgemäss erreicht durch Mittel zum Selbsthalten der Prüfspitze in einer Steckdosenbuchse bliebiger Bauart.

Hierbei umfassen erfindungsgemäss die Mittel zum Selbsthalten eine, an einem Kontaktstift teilweise anliegende, zur Kontaktstiftspitze hin doppelseitig ausbauchende Kontaktfeder, wobei Kontaktstift und Kontaktfeder vorzugsweise flächig ausgebildet sind.

Eine bevorzugte Ausführungsform ist ferner gegeben durch eine axial gegen die Wirkung einer Feder in das Gehäuse der Prüfspitze verschiebbare, die Kontaktfeder wenigstens teilweise umgebende Berührungsschutzhülse.

Aus diesen Massnahmen ergibt sich eine universell einsetzbare, sich in jeder Buchsenform unterschiedlichster Steckdosen selbsthaltende Prüfspitze, wobei jederzeit Berührungsschutz gewährleistet ist.

Eine beispielsweise Ausführungsform des Erfindungsgegenstandes ist nachfolgend anhand der Zeichnung näher erläutert. Es zeigen:

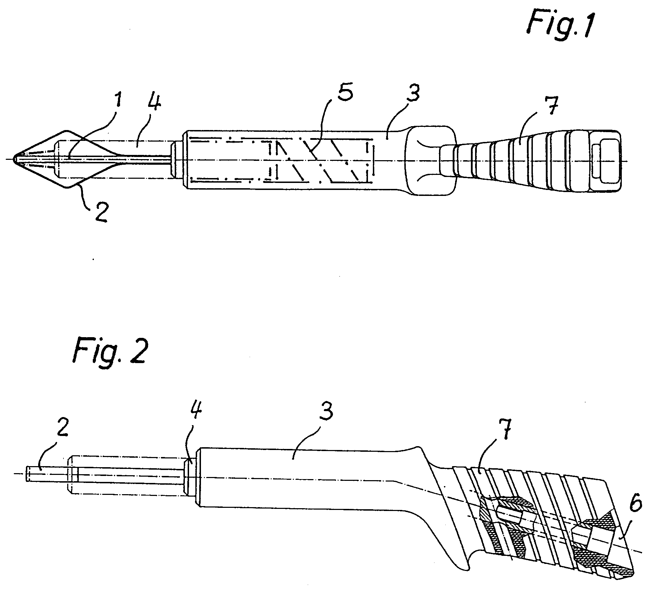

- Fig. 1: in schematischer Draufsicht eine zum steckbaren Anschluss an ein Gerätekabel bestimmte Prüfspitze; und
- Fig. 2: die Anordnung gemäss Fig. 1 in Seitenansicht.

Die dargestellte Prüfspitze für etwa einen Spannungsmesser umfasst ein Gehäuse 3, das in einen Handgriff 7 übergeht. In üblicher Weise steht dabei ein Kontaktstift 1 in elektrischer Verbindung mit einer Steckerhülse 6 am freien Ende des Handgriffes 7 für einen steckbaren Anschluss eines Gerätekabels.

Erfindungswesentlich sind hier nun Mittel zum Selbsthalten der Prüfspitze in einer Steckdosenbuchse beliebiger Bauart, welche Mittel eine, am Kontaktstift 1 teilweise anliegende, zur Kontaktstiftspitze hin doppelseitig ausbauchende Kontaktfeder 2 umfassen.

Hierbei sind der Kontaktstift 1 und die Kontaktfeder 2 vorzugsweise flächig ausgebildet.

Erfindungsgemäss kommt hier ferner dem Berührungsschutz grosse Bedeutung zu. Dies wird erreicht durch eine axial gegen die Wirkung einer Feder 5 in das Gehäuse 3 der Prüfspitze verschiebbare, die Kontaktfeder 2 wenigstens teilweise umgebende Berührungsschutzhülse 4.

Diese Hülse 4 verschiebt sich beim Einstecken der Prüfspitze in eine Steckdosenbuchse gegen die Wirkung der Feder 5 in das Gehäuse 3, wobei die Stirnseite der Hülse 4 am Buchsenrand aufliegt und dort die Prüfspitze zusätzlich selbsthaltend stabilisiert.

## Patentansprüche

1. Prüfspitze für elektrische Messgeräte, insbesondere Spannungsmesser, gekennzeichnet durch Mittel zum Selbsthalten der Prüfspitze in einer Steckdosenbuchse beliebiger Bauart.

2. Prüfspitze nach Anspruch 1, dadurch gekennzeichnet, dass die Mittel zum Selbsthalten eine, an einem Kontaktstift (1) teilweise anliegende, zur Kontaktstiftspitze hin doppelseitig ausbauchende Kontaktfeder (2) umfassen.

3. Prüfspitze nach Anspruch 2, dadurch gekennzeichnet, dass der Kontaktstift (1) und die Kontaktfeder (2) flächig ausgebildet sind.

4. Prüfspitze nach einem oder mehreren der vorangehenden Ansprüche 1 bis 3, gekennzeichnet durch eine axial gegen die Wirkung einer Feder (5) der Prüfspitze verschiebbare, die Kontaktfeder (2) wenigstens teilweise umgebende Berührungsschutzhülse (4).
